# EUROPEAN PATENT SPECIFICATION

(11) **EP 4 036 991 B1**
(45) Date of publication and mention of the grant of the patent: **20.11.2024**
(21) Application number: 20867943.1
(22) Date of filing: 18.09.2020
(51) Int. Cl.: H01L 31/0224, H01B 1/22

(54) **SOLAR BATTERY ALUMINUM PASTE**
ALUMINIUMPASTE FÜR SOLARBATTERIE
PÂTE D'ALUMINIUM POUR BATTERIE SOLAIRE

(30) Priority: 26.09.2019 JP 2019176033
(43) Date of publication of application: 03.08.2022
(73) Proprietor: Toyo Aluminium Kabushiki Kaisha, Osaka-shi, Osaka 541-0056 (JP)
(72) Inventor: DHAMRIN, Marwan, Osaka-shi, Osaka 541-0056 (JP)
(74) Representative: Marks & Clerk LLP
(86) International application number: PCT/JP2020/035440
(87) International publication number: WO 2021/060183

(56) References cited:
- WO-A1-2018/135430
- WO-A1-2018/135430
- WO-A1-2018/180441
- WO-A1-2018/180441
- JP-A- 2016 213 284
- US-A1- 2012 178 207
- US-A1- 2013 160 835
- SATO, EIICHIRO ET AL.: "Study on the phase diagram of Al-Si-Sr ternary alloy system", JOURNAL OF JAPAN INSTITUTE OF LIGHT METALS, vol. 35, no. 2, 1985, pages 71 - 78, XP055809500

## Description

### Technical Field

The present invention relates to an aluminum paste for solar cells, and particularly to an aluminum paste for forming aluminum electrodes in silicon crystalline solar cells.

### Background Art

In crystalline solar cells with high conversion efficiency, such as passivated emitter and rear contact (PERC) cells, passivated emitter and rear totally diffused (PERT) cells, interdigitated back contact (IBC) cells, and tunnel oxide passivated contacts (TOPCon) cells, various techniques have been developed to improve adhesiveness of an aluminum electrode to a silicon substrate. For example, Patent Literature 1 discloses a method of improving adhesiveness of an aluminum electrode to a silicon substrate by adding silicon to an aluminum powder in a solar cell aluminum paste for forming aluminum electrodes. WO2018135430 and WO2018180441 disclose aluminium pastes for improving conversion efficiency of solar cells.

### Citation List

### Patent Literature

PTL 1: JP2016-213284A

### Summary of Invention

### Technical Problem

However, in the technology of Patent Literature 1, the more silicon is added to the aluminum powder, the better the adhesiveness of the aluminum electrode to the silicon substrate; however, the more silicon is added, the lower the conductivity of the aluminum electrode, increasing the sheet resistance. Specifically, as the amount of silicon increases, there is a problem such that the conversion efficiency of a solar cell decreases.

Accordingly, a main object is to provide an aluminum paste for solar cells in which a reduction in the conversion efficiency of solar cells is suppressed even when silicon is contained.

### Solution to Problem

The present inventors conducted extensive research to achieve the above object. As a result, they found that the object can be achieved by an aluminum paste for solar cells that contains a specific component in addition to aluminum and silicon, and accomplished the present invention.

Specifically, the present invention relates to the following aluminum paste for solar cells.
1. An aluminum paste for solar cells, containing aluminum, silicon, and strontium, wherein strontium is in metal form, wherein when the total mass of the aluminum, silicon, and strontium is defined as 100 mass%, the content of the silicon is 1 mass% or more and 60 mass% or less, the content of the strontium is 0.001 mass% or more and 10 mass% or less, and the remainder is the aluminum.
2. The aluminum paste for solar cells according to Item 1, wherein the aluminum and the silicon are partially or wholly in the form of aluminum-silicon alloy powder.

### Advantageous Effects of Invention

According to the aluminum paste for solar cells of the present invention, a reduction in the conversion efficiency of solar cells can be suppressed in spite of the presence of silicon by incorporating strontium in addition to aluminum and silicon.

### Brief Description of Drawings

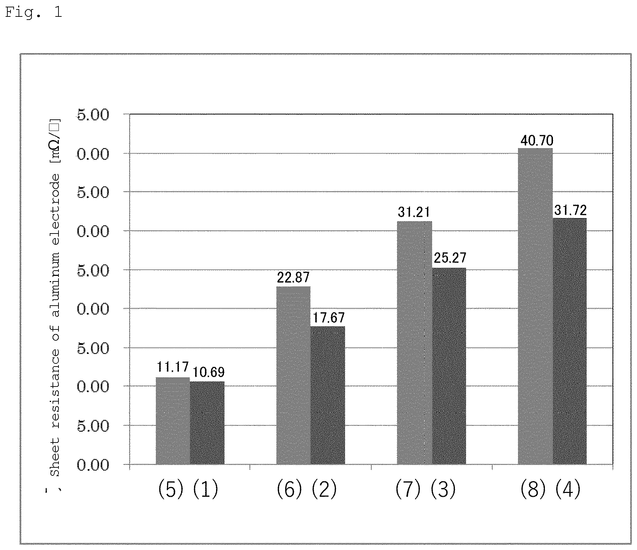

Fig. 1 shows a comparison of the sheet resistance of an aluminum electrode on the back surface of each of the solar cells produced in the Examples and Comparative Examples.

### Description of Embodiments

The aluminum paste for solar cells of the present invention (hereinafter also referred to as the "paste of the present invention") contains aluminum, silicon, and strontium, wherein when the total mass of the aluminum, silicon, and strontium is defined as 100 mass%, the content of the silicon is 1 mass% or more and 60 mass% or less, the content of the strontium is 0.001 mass% or more and 10 mass% or less, and the remainder is the aluminum.

In addition to the above metal components, the paste of the present invention may contain an organic vehicle used for making a paste, and further contain a glass powder as an optional additive to improve adhesiveness of an aluminum electrode to a silicon substrate.

According to the paste of the present invention having the above features, a reduction in the conversion efficiency of solar cells can be suppressed in spite of the presence of silicon by incorporating strontium in addition to aluminum and silicon.

### Aluminum, Silicon, and Strontium

The paste of the present invention is an aluminum paste (aluminum-containing paste), and contains silicon and strontium in predetermined amounts in addition to aluminum. The aluminum and silicon may be respectively a (single) aluminum powder and a (single) silicon powder, or an aluminum-silicon alloy powder. In the present invention, the use of an aluminum-silicon alloy powder is particularly preferred in view of ease of mixing.

These (single) powders and alloy powder may contain any impurities to the extent that the electrical properties of the ultimately obtained aluminum electrode are not affected. There is almost no possibility that strontium is present as an impurity; however, if it is present, strontium as an impurity is also included in the strontium in the paste. Commercially available products can be used as an aluminum powder, silicon powder, and aluminum-silicon alloy powder.

Strontium can be incorporated into the paste separately from aluminum and silicon. Usually, strontium in the form of powder is used. Thus, aluminum, silicon, and strontium in the form of powder are preferred because they can be easily dispersed in the paste. For a strontium powder, commercially available products can be used. In the present invention, it is believed that the incorporation of strontium suppresses the formation of coarse crystals of silicon due to the presence of silicon, and disperses the crystals to keep the sheet resistance of an aluminum electrode low, thereby suppressing a reduction in the conversion efficiency of solar cells.

The size and shape of the aluminum powder, silicon powder, aluminum-silicon alloy powder, and strontium powder are not limited. A powder having a volume average particle size D50 of 1 to 10 um is preferred, and a powder having a D50 of 5 to 8 um is more preferred. The shape of the powder can be selected from a spherical shape, an elliptical shape, a scale-like shape, an irregular shape, or the like.

In the paste of the present invention, the contents of the above three components are such that when the total mass of aluminum, silicon, and strontium is defined as 100 mass%, the content of the silicon may be 1 mass% or more and 60 mass% or less, the content of the strontium may be 0.001 mass% or more and 10 mass% or less, and the remainder may be the aluminum; and more preferably, the content of the silicon is 10 mass% or more and 50 mass% or less, and the content of the strontium is 0.01 mass% or more and 1 mass% or less (particularly 0.05 mass% or more and 1 mass% or less). By setting the contents within such a range, a reduction in the conversion efficiency of solar cells can be suppressed within the range of the aforementioned silicon content.

### Organic Vehicle

The organic vehicle is not limited, and those known in the field of pastes for forming aluminum electrodes of solar cells can be used. As the organic vehicle, a material in which additives and/or resins are dissolved or mixed as required in a solvent can be used. Alternatively, a resin itself can be used as an organic vehicle, without containing a solvent.

Known solvents can be used, and examples include diethylene glycol monobutyl ether, diethylene glycol monobutyl ether acetate, dipropylene glycol monomethyl ether, and the like.

Examples of additives include antioxidants, corrosion inhibitors, antifoaming agents, thickeners, tackifiers, coupling agents, static-electricity-imparting agents, polymerization inhibitors, thixotropic agents, antisettling agents, and the like. Specific examples include polyethylene glycol ester compounds, polyethylene glycol ether compounds, polyoxyethylene sorbitan ester compounds, sorbitan alkyl ester compounds, aliphatic polycarboxylic acid compounds, phosphoric acid ester compounds, amidoamine salts of polyester acids, polyethylene oxide compounds, fatty acid amide waxes, and the like.

Various resins can be used, and the following resins can be used in a combination of two or more: ethyl cellulose, nitrocellulose, polyvinyl butyral, phenol resins, melanin resins, urea resins, xylene resins, alkyd resins, unsaturated polyester resins, acrylic resins, polyimide resins, furan resins, urethane resins, isocyanate compounds, cyanate compounds, and like thermosetting resins, polyethylene, polypropylene, polystyrene, ABS resins, polymethyl methacrylate, polyvinyl chloride, polyvinylidene chloride, polyvinyl acetate, polyvinyl alcohol, polyacetal, polycarbonate, polyethylene terephthalate, polybutylene terephthalate, polyphenylene oxide, polysulfone, polyimide, polyether sulfone, polyarylate, polyetheretherketone, polytetrafluoroethylene, silicone resins, and the like.

The proportion of the resin, solvent, and additives in the organic vehicle can be adjusted as desired. For example, the component ratio can be the same as that of a known organic vehicle.

The content ratio of the organic vehicle in the paste of the present invention is not particularly limited. From the viewpoint of ensuring excellent printability of the paste, the content of the organic vehicle is preferably 10 parts by mass or more and 500 parts by mass or less, and more preferably 20 parts by mass or more and 45 parts by mass or less, relative to the total amount (100 parts by mass) of aluminum, silicon, and strontium.

### Glass Powder

The glass powder is an optional additive for improving adhesiveness of the aluminum electrode to the silicon substrate. Those known in the field of pastes for forming aluminum electrodes of solar cells can be used.

The glass powder usually contains one or two or more members selected from the group consisting of lead (Pb), bismuth (Bi), vanadium (V), boron (B), silicon (Si), tin (Sn), phosphorus (P), and zinc (Zn). The glass powder can be broadly classified into a glass powder containing lead and a lead-free glass powder, such as bismuth, vanadium, tin-phosphorus, zinc borosilicate, and alkali borosilicate glass powders. Of these, the use of a lead-free glass powder is desirable particularly in view of effect on the human body.

The softening point of the glass powder is not limited, and is preferably 650°C or less. Further, the volume average particle size D50 of glass particles composing the glass powder is not limited, and is preferably 1 to 3 um.

The content ratio of the glass powder in the paste of the present invention is not particularly limited. From the viewpoint of the balance between the adhesiveness of the aluminum electrode to the silicon substrate and the electrical resistance of the aluminum electrode, the content of the glass powder is preferably 0.5 parts by mass or more and 60 parts by mass or less, and more preferably 4 parts by mass or more and 15 parts by mass of less, relative to 100 parts by mass of aluminum, silicon, and strontium.

The paste of the present invention can be prepared by mixing the above components, and stirring the mixture by a known stirring means (e.g., a disperser or three roll mill).

### Examples

The present invention is described in detail below with reference to Examples and Comparative Examples. However, the present invention is not limited to the Examples.

### Example 1

2.0 parts by mass of a glass frit, 100 parts by mass of an aluminum-5% silicon alloy powder having a D50 of 6.0 µm produced by a gas atomization method, and 0.05 parts by mass of a strontium powder are mixed by using a disperser with 35 parts by mass of a resin solution obtained by dissolving ethyl cellulose in butyl diglycol, thus forming a paste. In Example 1, when the total mass of aluminum, silicon, and strontium was defined as 100 mass%, the content of silicon was 5 mass%, and the content of strontium was 0.05 mass%.

On the other hand, solar cells were produced as follows.

A passivated emitter and rear-type single crystalline silicon substrate having a resistance value of 3 Ω·cm on which an opening was provided beforehand by using a laser or the like was prepared. The paste was printed on the back surface side (surface opposite to the light-receiving surface) of the silicon substrate in an amount of 1.0 to 1.1 g/pc. Herein, the pc (piece) means one piece of a wafer called an M2 wafer (a cell of 156 mm x 156 mm with an area of about 244 cm²).

Then, a known Ag paste was printed on the light-receiving surface of the silicon substrate.

Thereafter, using an infrared belt furnace set to 800°C, an Ag electrode was formed on the light-receiving surface and an aluminum electrode was formed on the back surface side of the silicon substrate.

Subsequently, the sheet resistance of the aluminum electrode on the back surface side of the obtained solar cell was measured with a four-terminal type surface resistance measurement instrument (RG-5 model sheet resistance measurement instrument produced by Napson Corporation). The measurement conditions were voltage: 4 mV, current: 100 mA, and load applied to the surface: 200 grf (1.96 N). The results showed that the sheet resistance was 10.69 mΩ/□ (Fig. 1 (1)).

### Example 2

A solar cell was produced in the same manner as in Example 1 except that 100 parts by mass of an aluminum-10% silicon alloy powder was used in place of 100 parts by mass of the aluminum-5% silicon alloy powder. In Example 2, when the total mass of aluminum, silicon, and strontium was defined as 100 mass%, the content of silicon was 10 mass%, and the content of strontium was 0.05 mass%.

The sheet resistance of the aluminum electrode on the back surface side was measured in the same manner as in Example 1. The results showed that it was 17.67 mΩ/□ (Fig. 1 (2)).

### Example 3

A solar cell was produced in the same manner as in Example 1, except that 100 parts by mass of an aluminum-15% silicon alloy powder was used in place of 100 parts by mass of the aluminum-5% silicon alloy powder. In Example 3, when the total mass of aluminum, silicon, and strontium was defined as 100 mass%, the content of silicon was 15 mass%, and the content of strontium was 0.05 mass%.

The sheet resistance of the aluminum electrode on the back surface side was measured in the same manner as in Example 1. The results showed that it was 25.27 mΩ/□ (Fig. 1 (3)).

### Example 4

A solar cell was produced in the same manner as in Example 1, except that 100 parts by mass of an aluminum-20% silicon alloy powder was used in place of 100 parts by mass of the aluminum-5% silicon alloy powder. In Example 4, when the total mass of aluminum, silicon, and strontium was defined as 100 mass%, the content of silicon was 20 mass%, and the content of strontium was 0.05 mass%.

The sheet resistance of the aluminum electrode on the back surface side was measured in the same manner as in Example 1. The results showed that it was 31.72 mΩ/□ (Fig. 1 (4)).

### Comparative Example 1

A solar cell was produced in the same manner as in Example 1, except that the strontium powder was not added. In Comparative Example 1, when the total mass of aluminum, silicon, and strontium was defined as 100 mass%, the content of silicon was 5 mass%, and the content of strontium was 0 mass%.

The sheet resistance of the aluminum electrode on the back surface side was measured in the same manner as in Example 1. The results showed that it was 11.17 mΩ/□ (Fig. 1 (5)).

### Comparative Example 2

A solar cell was produced in the same manner as in Example 2, except that the strontium powder was not added. In Comparative Example 2, when the total mass of aluminum, silicon, and strontium was defined as 100 mass%, the content of silicon was 10 mass%, and the content of strontium was 0 mass%.

The sheet resistance of the aluminum electrode on the back surface side was measured in the same manner as in Example 1. The results showed that it was 22.87 mΩ/□ (Fig. 1 (6)).

### Comparative Example 3

A solar cell was produced in the same manner as in Example 3, except that the strontium powder was not added. In Comparative Example 3, when the total mass of aluminum, silicon, and strontium was defined as 100 mass%, the content of silicon was 15 mass%, and the content of strontium was 0 mass%.

The sheet resistance of the aluminum electrode on the back surface side was measured in the same manner as in Example 1. The results showed that it was 31.21 mΩ/□ (Fig. 1 (7)).

### Comparative Example 4

A solar cell was produced in the same manner as in Example 4, except that a strontium powder was not added. In Comparative Example 4, when the total mass of aluminum, silicon, and strontium was defined as 100 mass%, the content of silicon was 20 mass%, and the content of strontium was 0 mass%.

The sheet resistance of the aluminum electrode on the back surface side was measured in the same manner as in Example 1. The results showed that it was 40.70 mΩ/□ (Fig. 1 (8)).

The results of these Examples and Comparative Examples were summarized in Fig. 1. Examples 1 to 4 correspond to (1) to (4) in Fig. 1, and Comparative Examples 1 to 4 correspond to (5) to (8) in Fig. 1. As shown in Fig. 1, since the aluminum paste for solar cells of the present invention contains strontium in addition to aluminum and silicon, a reduction in the conversion efficiency of solar cells can be suppressed in spite of the presence of silicon.

## Claims

1. An aluminum paste for solar cells, containing aluminum, silicon, and strontium,
wherein strontium is in metal form, and
when the total mass of the aluminum, silicon, and strontium is defined as 100 mass%, the content of the silicon is 1 mass% or more and 60 mass% or less, the content of the strontium is 0.001 mass% or more and 10 mass% or less, and the remainder is the aluminum.

2. The aluminum paste for solar cells according to claim 1, wherein the aluminum and the silicon are partially or wholly in the form of aluminum-silicon alloy powder.

## Patentansprüche

1. Aluminiumpaste für Solarzellen, die Aluminium, Silizium und Strontium enthält,
wobei Strontium in metallischer Form vorliegt, und
wenn die Gesamtmasse des Aluminiums, des Siliziums und des Strontiums als 100 Masse-% definiert ist, der Gehalt des Siliziums 1 Masse-% oder mehr und 60 Masse-% oder weniger beträgt, der Gehalt des Strontiums 0,001 Masse-% oder mehr und 10 Masse-% oder weniger beträgt, und der Rest das Aluminium ist.

2. Aluminiumpaste für Solarzellen nach Anspruch 1, wobei das Aluminium und das Silizium teilweise oder ganz in Form von Aluminium-Silizium-Legierungspulver vorliegen.

## Revendications

1. Pâte d'aluminium pour cellules solaires, contenant de l'aluminium, du silicium et du strontium,
dans laquelle le strontium est sous une forme métallique, et
lorsque la masse totale de l'aluminium, du silicium et du strontium est définie comme étant 100 % en masse, la teneur en silicium est de 1 % en masse ou plus et de 60 % en masse ou moins, la teneur en strontium est de 0,001 % en masse ou plus et de 10 % en masse ou moins, et le reste est de l'aluminium.

2. Pâte d'aluminium pour cellules solaires selon la revendication 1, dans laquelle l'aluminium et le silicium sont partiellement ou totalement sous forme d'une poudre d'alliage aluminium-silicium.
